# EUROPEAN PATENT APPLICATION

(11) **EP 2 581 804 A1**
(43) Date of publication of application: **17.04.2013**
(21) Application number: 12156558.4
(22) Date of filing: 22.02.2012
(51) Int. Cl.: G06F 1/32, G06F 12/02, G11C 16/34, G06F 9/44

(54) **Electronic apparatus using NAND flash and memory management method thereof**

(30) Priority: 21.09.2011 TW 100133971
(71) Applicant: Acer Incorporated, New Taipei City 221 (TW)
(72) Inventor: Lin, Yung-Sen, New Taipei City 221, (TW); Shyu, Ruey-Ching, New Taipei City 221, (TW)
(74) Representative: Chamberlain, Alan James

(57) **Abstract**

An electronic apparatus using NAND flash memory and a memory management method thereof are provided. The electronic apparatus uses the NAND flash memory to record data in the system memory. In the present method, when a standby instruction is received, a fast flash standby (FFS) procedure is initiated, and a state of the NAND flash memory is checked to determine whether the NAND flash memory is suitable for recording the data in the system memory. If the state is determined as suitable for recording the data, the data in the system memory is copied to the NAND flash and the operating system of the electronic apparatus is controlled to enter a hibernate mode. On the contrary, if the state is determined as not suitable for recording the data, the operating system of the electronic apparatus is controlled to enter a standby mode.

## Description

### CROSS-REFERENCE TO RELATED APPLICATION

This application claims the priority benefit of Taiwan application serial no. 100133971, filed on September 21, 2011. The entirety of the above-mentioned patent application is hereby incorporated by reference herein and made a part of this specification.

### BACKGROUND OF THE INVENTION

### Field of the Invention

The invention relates to an electronic apparatus using a memory and a memory management method thereof. Particularly, the invention relates to an electronic apparatus using a NAND flash memory and a memory management method thereof.

### Description of Related Art

Recently, Intel Corporation introduced the technology of Fast Flash Standby (FFS) procedure. The FFS procedure is initiated when the user of an electronic apparatus issues a standby instruction. The FFS procedure copies data recorded in the system memory to a NAND flash memory, or to a solid state disk (SSD) produced by the NAND flash memory. The power supply to the system memory and the NAND flash memory is then disconnected. Therefore, a power saving state similar to a hibernation mode is achieved.

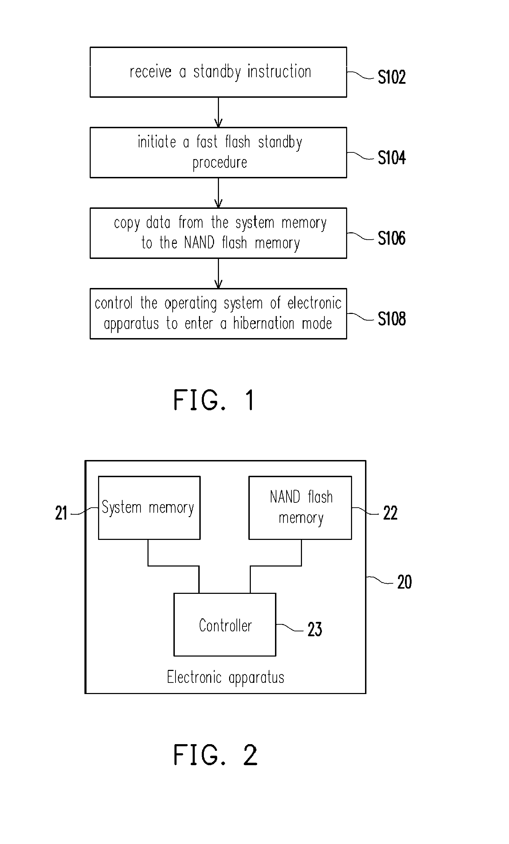

FIG. 1 is a flowchart of the FFS procedure. Referring to FIG. 1, when the electronic apparatus receives a standby instruction issued by a user (step S102), the FFS procedure is initiated (step S104), and data recorded in a system memory is copied to a NAND flash memory (step S106). After the copy is completed, the operating system of the electronic apparatus is controlled to enter a hibernation mode (S108). At this time, the electronic apparatus disconnects the power supply to the system memory and the NAND flash memory to save power.

When the user restarts the electronic apparatus, the data recorded in the NAND flash memory is restored to the system memory and the operating system of the electronic apparatus is returned to normal mode. Because of the fast access time and non-volatility of NAND flash memory, the FFS procedure shortens the time required for the operating system to enter or exit the hibernation mode. By using the FFS, the time required for the operating system to enter or exit the hibernation mode is similar to the time generally needed to enter or exit the standby mode. Because the NAND flash memory does not need power supply in the FFS standby mode, the electronic apparatus consumes an amount of power similar to that of the hibernation mode.

However, the reliability of semiconductor structures is time limited. NAND flash memory and SSD both have reliability issues in that the number of memory write cycles can not exceed a maximum limit. With the increasing of write cycles, the cells of NAND flash memory begin to deteriorate, and the available memory capacity begin to decrease. Because the FFS procedure performs write cycles to the Flash memory very frequently, with the increasing of usage time of the electronic apparatus, it is possible that a substantial number of NAND flash memory cells are damaged such that there is not enough capacity to record the data to be stored into the NAND flash memory by the FFS procedure. Thereby, a loss of data is incurred when the FFS procedure put the system into the standby or hibernation mode.

### SUMMARY OF THE INVENTION

The invention is directed to a memory management method and an electronic apparatus using a NAND flash memory, by which a state of the NAND flash memory is checked to determine whether to enter the hibernation mode by using the FFS procedure. As a result, data loss is prevented.

The invention provides a memory management method suitable for an electronic apparatus using the NAND flash memory to record the data in the system memory. When a standby instruction is received, a FFS procedure is initialized, and a state of the NAND flash memory is checked to determine if the NAND flash memory is suitable for recording the data in the system memory. If the state is determined as suitable for recording the data, the data in the system memory is copied to the NAND flash memory, and the operating system of the electronic apparatus is controlled to enter a hibernation mode; otherwise, if the state is determined as not suitable for recording said data, the operating system of the electronic apparatus is controlled to enter a standby mode.

In one embodiment of the invention, the aforesaid step of checking the state of the NAND flash memory to determine if the NAND flash memory is suitable for recording the data in the system memory comprises checking if an available capacity of the NAND flash memory is greater than a memory capacity of the system memory. If the available capacity is greater than the memory capacity, the state of the NAND flash memory is determined as suitable for recording said data. If the available capacity is not greater than the memory capacity, the state of the NAND flash memory is determined as not suitable for recording said data.

In one embodiment of the invention, the step of checking the state of the NAND flash memory to determine if the NAND flash memory is suitable for recording the data in the system memory comprises checking if the NAND flash memory comprises a spare capacity. If the NAND flash memory comprises the spare capacity, the state of the NAND flash memory is determined as suitable for recording said data. If the NAND flash memory does not have the spare capacity, the state of the NAND flash memory is determined as not suitable for recording said data.

In one embodiment of the invention, if the state of the NAND flash memory is not suitable for recording the data in the system memory, said method further terminates the FFS procedure.

In one embodiment of the invention, after the hibernation mode is entered, the data recorded in the NAND flash memory is restored back to the system memory when a restart instruction is received, and the operating system of the electronic apparatus is returned to a normal mode.

The invention provides an electronic apparatus comprising a system memory, a NAND flash memory, and a controller. The system memory is used to record data. The controller is coupled to the system memory and the NAND flash memory, and is used to initiate a FFS procedure when a standby instruction is received, and check a state of the NAND flash memory to determine if the NAND flash memory is suitable for recording the data in the system memory. If the state is determined as suitable for recording the data, the data in the system memory is copied to the NAND flash memory and the operating system of the electronic apparatus is controlled to enter a hibernation mode. If the state is determined as not suitable for recording said data, the operating system of the electronic apparatus is controlled to enter a standby mode.

In one embodiment of the invention, the controller further checks if an available capacity of the NAND flash memory is greater than a memory capacity of the system memory. If said available capacity is greater than the memory capacity, the state is determined as suitable for recording said data. If said available capacity is not greater than the memory capacity, the state of the NAND flash memory is determined as not suitable for recording said data.

In one embodiment of the invention, the controller further checks if the NAND flash memory comprises a spare capacity. If the NAND flash memory comprises the spare capacity, the state is determined as suitable for recording said data. If the NAND flash memory does not comprise the spare capacity, the state is determined as not suitable for recording said data.

In one embodiment of the invention, if the state of the NAND flash memory is not suitable for recording the data in the system memory, said controller further terminates the FFS procedure.

In one embodiment of the invention, after the hibernation mode is entered, said controller procedure further restores the data recorded in the NAND flash memory back to the system memory when receiving a restart instruction and returns the operating system of the electronic apparatus to a normal mode.

In summary, the memory management method and the electronic apparatus using NAND flash memory of the invention check the state of the NAND flash memory to determine whether to enter the hibernation mode or the standby mode by using the FFS procedure. As a result, a successful execution of the FFS procedure is ensured, and data loss or irrecoverable errors in the process of entering the hibernation mode are prevented.

In order to make the aforementioned and other features and advantages of the invention comprehensible, several exemplary embodiments accompanied with figures are described in detail below.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.

FIG. 1 is a flowchart showing the existing FFS procedure.

FIG. 2 is a block diagram of the electronic apparatus according to one embodiment of the invention.

FIG. 3 is a flowchart of the memory management method according to one embodiment of the invention.

FIG. 4 is a flowchart of the memory management method according to one embodiment of the invention.

FIG. 5 is a flowchart of the memory management method according to one embodiment of the invention.

### DETAILED DESCRIPTION OF DISCLOSED EMBODIMENTS

Because the NAND flash memory and solid state disk (SSD) have reliability issues, the invention is directed to check the state of NAND flash memory before the electronic apparatus enters a hibernation mode. The FFS procedure is executed only when the NAND flash memory is in a healthy state so as to ensure that no data loss or irrecoverable errors are occurred after the electronic apparatus enters the hibernation mode.

FIG. 2 is a block diagram of the electronic apparatus according to one embodiment of the invention. Referring to FIG. 2, the electronic apparatus 20 comprises a system memory 21, a NAND flash memory 22 and a controller 23, and functions thereof are described in the following.

The system memory 21 is, for example, a volatile memory such as a dynamic random access memory (DRAM), a synchronous DRAM (SDRAM), a static random access memory (SRAM) or a DDR DRAM, and is used to store the data required for the operation of the electronic apparatus 20.

The NAND flash memory is one of non-volatile memory which can store data without power supply. The NAND flash memory has low read delay and high read and write efficiency. Therefore, the NAND flash memory is suitable for the FFS technology.

The controller 23 is, for example, a central processing unit (CPU), a microprocessor, a digital signal processor (DSP), a programmable controller, an application specific integrated circuit (ASIC), a programmable logic device (PLD) or other similar devices, and is used to execute operations of the electronic apparatus 20. The controller 23 is coupled to the system memory 21 and the NAND flash memory 22 so as to access the data stored in these memories.

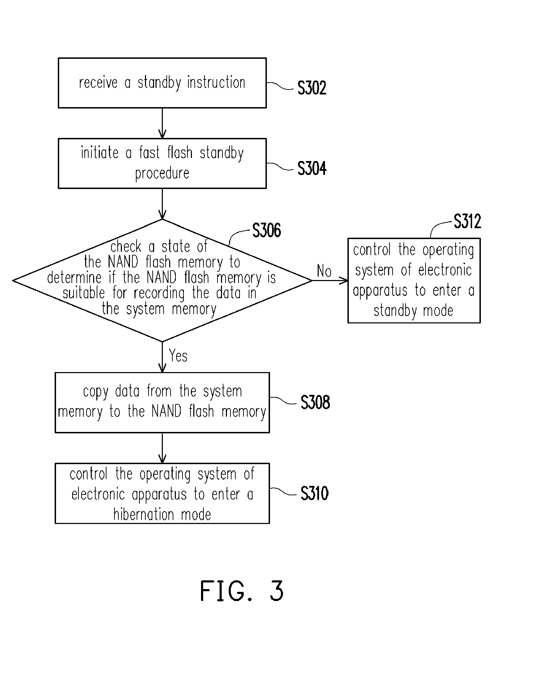

FIG. 3 is a flowchart of the memory management method according to one embodiment of the invention. Referring to FIG. 3, the steps of the memory management method of the embodiment are explained in the following.

First, the controller 23 receives a standby instruction (step S302). The standby instruction is triggered by either the user activating a hardware switch on the electronic apparatus 20 or executing a standby function in the operating system of the electronic apparatus 20.

When the standby instruction is received, the controller 23 initiates the FFS procedure (step S304), and prepares to backup the data recorded in the system memory 21 so as to enter the hibernation mode.

At this moment, the controller 23 checks a state of the NAND flash memory 22 to determine if the NAND flash memory is suitable for recording the data in the system memory 21 (step S306). If the state of the NAND flash memory 22 is determined as suitable for recording the data in the system memory 21, the controller 23 copies the data in the system memory 21 to the NAND flash memory 22 (step S308), and controls the operating system of the electronic apparatus 20 to enter a hibernation mode (step S310). Then, the electronic apparatus 20 disconnects the power supply to the NAND flash memory 22 so that power saving is achieved and the data stored in the NAND flash memory 22 is preserved.

On the contrary, if the state of the NAND flash memory 22 is determined as not suitable for recording said data, the controller 23 controls the operating system of the electronic apparatus 20 to enter a standby mode (step S312). At this moment, the controller 23 terminates the FFS procedure, and the electronic apparatus 20 continues to provide power supply to the system memory 21 so as to maintain a normal operation. Thereby, more power is consumed. In one embodiment, the controller 23 further terminates the FFS procedure in the step S312.

Furthermore, in one embodiment of the invention, after the hibernation mode is entered, the controller 23 restores the data recorded in the NAND flash memory 22 back to the system memory 21 when receiving a restart instruction, so as to return the operating system of the electronic apparatus 20 to the normal mode.

Through the above described method, the electronic apparatus 20 is ensured to have no data loss or irrecoverable errors when executing the FFS procedure to enter the hibernation mode.

Regarding how to check the state of the NAND flash memory to determine if the NAND flash memory is suitable for recording the data in the system memory, the invention provides two different implementations. Embodiments are respectively provided below for further illustration.

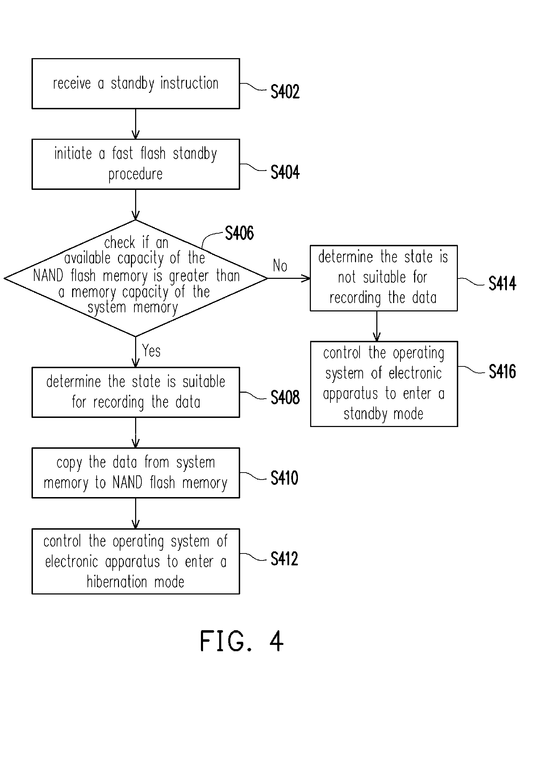

FIG. 4 is a flowchart of the memory management method according to one embodiment of the invention. Referring to FIG. 4, the steps of the memory management method of the embodiment are explained in the following.

First, the controller 23 receives a standby instruction (step S402), and initiates the FFS procedure (step S404). Meanwhile, the controller 23 checks whether an available capacity of the NAND flash memory 22 is greater than a memory capacity of the system memory 21 (step S406).

In detail, the requirement to successfully execute the FFS procedure is that the available capacity in the NAND flash memory 22 is large enough to accommodate the data recorded in the system memory 21 such that all the data in the system memory can be backed up. However, because the available capacity of the NAND flash memory 22 decreases gradually with the increasing of write cycles, eventually a condition arises that the available capacity of the NAND flash memory 22 becomes smaller than the memory capacity of the system memory 21. Under this condition, the FFS procedure can not be executed successfully and data loss and irrecoverable errors may happen. Therefore, the embodiment monitors the available capacity of the NAND flash memory 22 to ensure the successful execution of the FFS procedure.

Thereby, if the controller 23 determines that the available capacity of the NAND flash memory 22 is greater than the memory capacity of the system memory 21, the state of the NAND flash memory 22 is determined as suitable for recording the data in the system memory 21 (step S408). Accordingly, the controller 23 copies the data from the system memory 21 to the NAND flash memory 22 (step S410), and controls the operating system of the electronic apparatus 20 to enter a hibernation mode (step S412), so as to complete the FFS procedure.

On the contrary, if the controller 23 determines that the available capacity of the NAND flash memory 22 is not greater than the memory capacity of the system memory 21, the state of the NAND flash memory 22 is determined as not suitable for recording the data in the system memory 21 (step S414). Then, the operating system of the electronic apparatus 20 is controlled to enter a standby mode (step S416).

Through the method described above, it is ensured that no data loss or irrecoverable errors are occurred after the electronic apparatus 20 enters the hibernation mode by using the FFS procedure.

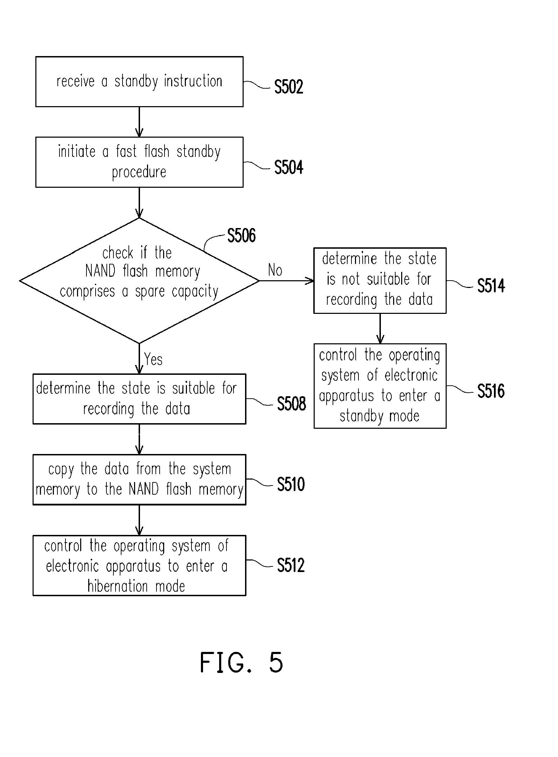

FIG. 5 is a flowchart of the memory management method according to another embodiment of the invention. Referring to FIG. 5, the steps of the memory management method of the embodiment are explained in the following.

First, the controller 23 receives a standby instruction (step S502), and initiates the FFS procedure (step S504). Meanwhile, the controller 23 checks whether there is a spare capacity in the NAND flash memory 22 (step S506) and accordingly determines whether to execute the FFS procedure.

In detail, because the available capacity of the NAND flash memory 22 decreases gradually with the increasing of write cycles, current NAND flash memory products provides a spare capacity. When the memory cells in a main memory are damaged, they are substituted by memory cells in the spare capacity. The available capacity of NAND flash memory is maintained at an acceptable level so that users do not feel the damage of the NAND flash memory.

Generally speaking, the spare capacity of the NAND flash memory may occupy 10% to 20% of the capacity of main memory, and even occupy up to 50%, so as to remain the capacity of the NAND flash memory unchanged for a longer time. However, once the spare capacity of NAND flash memory is exhausted, it means that a lot of memory cells in main memory are damaged and the remaining memory cells are close to an instable state. Therefore, the embodiment relies upon the fact whether the spare capacity is exhausted to determine if the NAND flash memory is suitable for recording the data in system memory, which allows the FFS procedure to execute successfully.

Based on the above, if the controller 23 determines that the NAND flash memory 22 has the spare capacity, the state of the NAND flash memory 22 is determined as suitable for recording the data in the system memory 21 (step S508). Accordingly, the controller 23 copies the data in the system memory 21 to the NAND flash memory 22 (step S510), and controls the operating system of the electronic apparatus 20 to enter a hibernation mode (step S512), so as to complete the FFS procedure.

On the contrary, if the controller 23 determines that the NAND flash memory 22 does not have the spare capacity, the state of the NAND flash memory 22 is determined as not suitable for recording the data in the system memory 21 (step S514). Accordingly, the controller 23 controls the operating system of the electronic apparatus 20 to enter a standby mode (step S516).

Through the method described above, it is ensured that no data loss or irrecoverable errors may happen after the electronic apparatus 20 enters the hibernation mode by using the FFS procedure.

In summary, the invention provides an electronic apparatus using a NAND flash memory and a memory management method thereof. Either by comparing the available capacity of the NAND flash memory against the memory capacity of the system memory, or by checking whether there are spare capacity in the NAND flash memory, the state of the NAND flash memory is determined whether suitable for recording the data in the system memory, so as to decide whether to enter the hibernation mode or the standby mode. Thereby, data loss or irrecoverable errors are prevented after the electronic apparatus enters the hibernation mode.

It will be apparent to those skilled in the art that various modifications and variations can be made to the structure of the invention without departing from the scope or spirit of the invention. In view of the foregoing, it is intended that the invention cover modifications and variations of this invention provided they fall within the scope of the following claims and their equivalents.

## Claims

1. A memory management method suitable for an electronic apparatus (20) using a NAND flash memory (22) to record data in the system memory (21), the method comprising:
receiving (S302) a standby instruction;
initiating (S304) a fast flash standby (FFS) procedure;
checking (S306) a state of the NAND flash memory (22) to determine if the NAND flash memory (22) is suitable for recording the data from the system memory (21);
if the state is determined as suitable for recording the data, copying (S308) the data in the system memory (21) to the NAND flash memory (22), and controlling (S310) the operating system of the electronic apparatus (20) to enter a hibernation mode; and
if the state is determined as not suitable for recording the data, controlling (S312) the operating system of the electronic apparatus (20) to enter a standby mode.

2. The memory management method as claimed in claim 1, wherein the step of checking the state of the NAND flash memory (22) to determine if the NAND flash memory (22) is suitable for recording the data in the system memory (21) comprises
checking (S406) if an available capacity of the NAND flash memory (22) is greater than a memory capacity of the system memory (21),
if said available capacity is greater than the memory capacity, determining (S408) the state of the NAND flash memory (22) is suitable for recording the data; and
if said available capacity is not greater than the memory capacity, determining (S414) the state of the NAND flash memory (22) is not suitable for recording the data.

3. The memory management method as claimed in claim 1, wherein the step of checking a state of the NAND flash memory (22) to determine if the NAND flash memory (22) is suitable for recording the data in the system memory (21) comprises:
checking (S506) if the NAND flash memory (22) comprises a spare capacity;
if the NAND flash memory (22) comprises the spare capacity, determining (S508) the state of the NAND flash memory (22) is suitable for recording said data; and
if the NAND flash memory (22) does not comprise the spare capacity, determining (S514) the state of the NAND flash memory (22) is not suitable for recording said data;

4. The memory management method as claimed in any one of claims 1 to 3, wherein if the state of the NAND flash memory (22) is not suitable for recording the data in the system memory (21), the method further comprises:
terminating the FFS procedure.

5. The memory management method as claimed in any one of claims 1 to 4, wherein after the hibernation mode is entered, the method further comprises:
receiving a restart instruction; and
restoring the data recorded in the NAND flash memory (22) back to the system memory (21), and returning the operating system of the electronic apparatus (20) to a normal mode.

6. An electronic apparatus (20) having a NAND flash memory (22), comprising,
a system memory (21), configured to record data;
a NAND flash memory (22); and
a controller (23), coupled to the system memory (21) and the NAND flash memory (22), configured to initiate a FFS procedure when receiving a standby instruction, and checking a state of the NAND flash memory (22) to determine if the NAND flash memory (22) is suitable for recording the data in the system memory (21), wherein
if the state is determined as suitable for recording the data, copying the data in the system memory (21) to the NAND flash memory (22), and controlling the operating system of the electronic apparatus (20) to enter a hibernation mode; and
if the state is determined as not suitable for recording the data, controlling the operating system of the electronic apparatus (20) to enter a standby mode.

7. The electronic apparatus as claimed in claim 6, wherein the controller (23) comprises checking if an available capacity of the NAND flash memory (22) is greater than a memory capacity of the system memory (21), wherein
if said available capacity is greater than the memory capacity, determining the state of the NAND flash memory (22) is suitable for recording said data; and
if the available capacity is not greater than the memory capacity, determining the state of the NAND flash memory (22) is not suitable for recording said data.

8. The electronic apparatus as claimed in claim 6, wherein the controller (23) comprises checking if the NAND flash memory (22) comprises a spare capacity, wherein
if the NAND flash memory (22) comprises the spare capacity, determining the state of the NAND flash memory (22) is suitable for recording said data; and
if the NAND flash memory (22) does not comprise the spare capacity, determining the state of the NAND flash memory (22) is not suitable for recording said data.

9. The electronic apparatus as claimed in any one of claims 6 to 8, wherein if the state of the NAND flash memory (22) is not suitable for recording the data in the system memory (21), the controller (23) terminates the FFS procedure.

10. The electronic apparatus as claimed in any one of claims 6 to 9, wherein the controller (23) further comprises receiving a restart instruction to restore the data recorded in the NAND flash memory (22) back to the system memory (21), and return the operating system of the electronic apparatus (20) to a normal mode.
